# EUROPEAN PATENT SPECIFICATION

(11) **EP 2 439 063 B1**
(45) Date of publication and mention of the grant of the patent: **25.02.2015**
(21) Application number: 10796975.0
(22) Date of filing: 03.06.2010
(51) Int. Cl.: B32B 15/08, H05K 9/00, B32B 7/02, B32B 15/20, H05K 1/09

(54) **COPPER FOIL COMPOSITE**
KUPFERFOLIENVERBUNDSTOFF
COMPOSITE DE FEUILLE DE CUIVRE

(30) Priority: 07.07.2009 JP 2009161068
(43) Date of publication of application: 11.04.2012
(73) Proprietor: JX Nippon Mining & Metals Corporation, Tokyo 100-8164 (JP)
(72) Inventor: KANMURI Kazuki, Hitachi-shi Ibaraki 317-0056 (JP)
(74) Representative: Prüfer & Partner GbR European Patent Attorneys
(86) International application number: PCT/JP2010/059416
(87) International publication number: WO 2011/004664

(56) References cited:
- JP-A- 3 112 643
- JP-A- 4 144 187
- JP-A- 2002 144 510
- JP-A- 2005 191 443
- JP-A- 2006 272 743
- JP-A- 2008 120 081
- JP-A- 2009 108 376
- US-B1- 6 217 996
- US-B1- 6 251 507

## Description

### Field of the Invention

The present invention relates to a copper foil composite suitable for an electromagnetic shielding material, a copper laminate for FPC and a substrate to be heat dissipated.

### Description of the Related Art

A copper foil composite comprising a copper foil and a resin film laminated thereon is used as an electromagnetic shielding material (see Patent Literature 1). The copper foil has electromagnetic shielding properties, and the resin film is laminated for reinforcing the copper foil. A method for laminating the resin film on the copper foil includes a method for laminating the resin film on the copper foil with an adhesive agent, and a method for vapor-depositing copper on the surface of the resin film. In order to ensure the electromagnetic shielding properties, the thickness of the copper foil should be several µm or more. Thus, a method for laminating the resin film on the copper foil is inexpensive.

In addition, the copper foil has excellent electromagnetic shielding properties. So, a material to be shielded is covered with the copper foil to shield all surfaces of the material. In contrast, if the material to be shielded is covered with a copper braid, the material to be shielded is exposed at mesh parts of the copper braid to decrease the electromagnetic shielding properties.

Other than the electromagnetic shielding material, a composite of a copper foil and a resin film (PET, polyimide (PI), a liquid crystal polymer (LCP) and the like) is used for a flexible printed circuit (FPC). In particular, PI is mainly used for the FPC.

Since the FPC may be deformed, e.g. flexed or bent, the FPC having excellent flexibility has been developed and is used for a mobile phone (see Patent Literature 2). In general, the flex or bend in flexed parts of the FPC is an unidirectional bending deformation, which is simple as compared with the deformation where the electromagnetic shielding material wound around electric wires is flexed. Therefore, the workability of composite for the FPC is not so required.

### [Prior Art Literature]

### [Patent Literature]

[Patent Literature 1] Japanese Unexamined Patent Publication No. Hei07-290449 [Patent Literature 2] Japanese Patent No. 3009383

US6217996 (D1) discloses a composite sheet for a flexible printed circuit board comprising an electrolyzed or rolled copper foil placed on a polyimide film.

### [Summary of the Invention]

### [Problems to be solved by the Invention]

The copper foil composite may be wound around the outside of a material to be shielded such as a cable and may be used as a shielding material. However, the copper foil is easily broken or cracked and is therefore difficult to be used in the application requiring bending or flexibility. In addition, the workability may be needed in the copper foil composite for the FPC depending on installation site.

Furthermore, the thicker copper foil has improved elongation, but the thinner one has significantly decreased ductility. On the other hand, the thicker copper foil has increased stiffness, so the shielding process where the copper foil composite is wound around the material to be shielded such as electric wires may be difficult. Thus, it is difficult to satisfy both the flexibility and the workability of the copper foil composite.

Accordingly, an object of the present invention is to provide a copper foil composite having enhanced workability.

### [Means for Solving the Problems]

The present inventors found that the crease performance can be enhanced by specifying the thickness or the strain of the copper foil and the resin layer constituting the copper foil composite, while not impairing the workability. Thus, the present invention is attained.

That is, the present invention provides a copper foil composite comprising a copper foil and a resin layer laminated thereon, wherein elongation after fracture of the copper foil is 5% or more, and wherein (F x T)/(f x t) => 1 is satisfied when t is a thickness of the copper foil, f is a stress of the copper foil under tensile strain of 4%, T is a thickness of the resin layer and F is a stress of the resin layer under tensile strain of 4%.

Preferably, the elongation after fracture of the copper foil composite is 30% or more.

Preferably, (F x T) =< 3.1 (N/mm) is satisfied.

Preferably, the copper foil contains at least one selected from the group consisting of Sn, Mn, Cr, Zn, Zr, Mg, Ni, Si and Ag at a total concentration of 200 to 2000 mass ppm.

### [Effect of the Invention]

According to the present invention, there is provided a copper foil composite having enhanced workability.

### [Description of the Embodiments]

The copper foil composite of the present invention comprises a copper foil and a resin layer laminated thereon.

### <Copper foil>

The elongation after fracture of the copper foil is 5% or more. When the elongation after fracture is less than 5%, the elongation of the copper foil composite is decreased even if (F x T)/(f x t) => 1 is satisfied as described later. As long as (F x T)/(f x t) => 1 is satisfied, it is preferable that the elongation after fracture of the copper foil be higher.

When the conductivity of the copper foil is 60% IACS or more, the shielding properties are enhanced. So, it is preferred that the purity of the copper foil be high, e.g., preferably 99.5% or more and more preferably 99.8% or more. The rolled copper foil having excellent flexibility is preferred. An electro-deposited copper foil may also be used.

The copper foil may contain other elements. A total content of these elements and inevitable impurities may be less than 0.5% by mass. In particular, when at least one selected from the group consisting of Sn, Mn, Cr, Zn, Zr, Mg, Ni, Si and Ag is contained in the copper foil at a total concentration of 200 to 2000 ppm, the elongation is preferably enhanced as compared with a pure copper foil having the same thickness.

For use as the electromagnetic shielding material, the thickness t of the copper foil is preferably 4 to 12 µm. When the thickness t is less than 4 µm, the shielding properties and the elongation after fracture are decreased, and the production of the copper foil and the lamination with the resin layer may be difficult. On the other hand, the greater thickness t increases the elongation after fracture. However, when the thickness t exceeds 12 µm, the stiffness is increased, and the workability of the copper foil composite may be lowered. When the thickness t exceeds 12 µm, (F x T)/(f x t) => 1 of the copper foil composite is not satisfied as described later, and the elongation after fracture of the copper foil composite tends to be rather decreased. In particular, when the thickness t exceeds 12 µm, the thickness T needs to be thickened in order to satisfy (F x T)/(f x t) => 1, and (F x T) may therefore exceed 3.1.

On the other hand, for use as the FPC and a substrate to be heat dissipated, the thickness t of the copper foil is preferably 4 to 40 µm. For the FPC and a substrate to be heat dissipated, the flexibility of the copper foil composite is not so required as compared with the electromagnetic shielding material. So, the maximum value of the thickness t can be 40 µm. When PI is used as the resin layer, PI has high intensity so that (F x T)/(f x t) => 1 can be satisfied even though the thickness t of the copper foil is great. For the substrate to be heat dissipated, no circuit is formed in the copper foil of the FPC, and the copper foil is well adhered to the substrate to be heat dissipated.

### <Resin layer>

The resin layer is not especially limited. The resin layer may be formed by applying a resin material to the copper foil. The resin film which can be bonded to the copper foil is preferable. Examples of the resin film include a polyethylene terephthalate (PET) film, a polyimide (PI) film, a liquid crystal polymer (LCP) film and a polypropylene (PP) film. Especially, the PET film can be suitable. Furthermore, when a biaxially-stretched film is used as the PET film, the strength can be enhanced.

The thickness T of the resin layer is not especially limited. For the electromagnetic shielding material, the thickness T is generally about 7 to 25 µm. When the thickness T is less than 7 µm, the value (F x T) described later is decreased, (F x T)/(f x t) => 1 is not satisfied, and the (elongation) elongation after fracture of the copper foil composite tends to be decreased. On the other hand, when the thickness T exceeds 25 µm, the (elongation) elongation after fracture of the copper foil composite tends to be decreased, and (F x T) possibly exceeds 3.1.

The resin film may be laminated on the copper foil by using an adhesive agent between the resin film and the copper foil, or by thermally compressing the resin film and the copper foil without using the adhesive agent. From the standpoint that no excess heat is applied to the resin film, the adhesive agent is preferably used. It is preferred that the thickness of the adhesive agent layer be 6 µm or less. When the thickness of the adhesive agent layer exceeds 6 µm, only the copper foil is easily broken after it is laminated on the copper foil composite.

On the other hand, for the FPC or the substrate to be heat dissipated, the thickness T of the resin layer is generally about 7 to 70 µm. When the thickness T is less than 7 µm, the value (F x T) described later is decreased, (F x T)/(f x t) => 1 is not satisfied, and the (elongation) elongation after fracture of the copper foil composite tends to be decreased. On the other hand, when PI is used as the resin layer, the ductility is not significantly decreased even if (F x T) exceeds 3.1, since PI can be well adhered as compared with PET.

When the resin layer and the adhesive agent layer can be distinguished and be separated, the F and T of "the resin layer" of the present invention are measured excluding the adhesive agent layer. However, when the resin layer and the adhesive agent layer cannot be distinguished, only the copper foil is dissolved in the copper foil composite, and the "the resin layer" may be measured including the adhesive agent layer. This is because the resin layer is generally thicker than the adhesive agent layer, and the values of F and T are not significantly changed when compared between the resin layer alone and the resin layer including the adhesive agent layer.

For the FPC, both surfaces of the copper foil may be the resin layers by attaching coverlay films. In this case, the values of F and T of each resin layer include the strength and the thickness of the coverlay films.

A Sn plating layer having a thickness of about 1 µm for improving corrosion resistance (salt damage resistance) may be formed on the surface of the copper foil opposite to the surface on which the resin layer is formed.

Also, in order to enhance the adhesion between the resin layer and the copper foil, the copper foil may be surface-treated such as roughening treatment. The surface treatments described in Japanese Unexamined Patent Publication No. 2002-217507, Japanese Unexamined Patent Publication No. 2005-15861, Japanese Unexamined Patent Publication No. 2005-4826, Japanese Examined Patent Publication No. Hei 7-32307 and the like can be used.

The present inventors found that the crease performance can be enhanced by specifying the thickness and the strain of the copper foil and the resin layer constituting the copper foil composite, while not impairing the workability.

It has been found that the ductility is high and the crease performance are enhanced in the copper foil composite wherein (F x T)/(f x t) => 1 is satisfied when t is a thickness of the copper foil, f is a stress of the copper foil under tensile strain of 4%, T is a thickness of the resin layer and F is a stress of the resin layer under tensile strain of 4%.

The reason thereof is uncertain. However, the reasons may be as follows: Each of (F x T) and (f x t) represents a stress per unit width (e.g., (N/mm)). And the copper foil and the resin layer laminated thereon have the same width. Therefore, (F x T)/(f x t) represents a ratio of the strength applied to the copper foil and the resin layer constituting the copper foil composite. When the ratio is 1 or more, much force is applied to the resin layer and the resin layer is stronger than the copper foil. As a result, the copper foil is susceptible to the effect of the resin layer, the copper foil is elongated uniformly, and it is considered that the ductility of the copper foil composite is increased.

Here, F and f may be the stress at the same strain amount after plastic deformation. In consideration of the elongation after fracture of the copper foil and the strain at the time of starting the plastic deformation of the resin layer (for example, PET film), the tensile strain of 4% is set. F can be measured by a tensile test of the copper foil remained after the removal of the resin layer from the copper foil composite by use of a solvent. Similarly, f can be measured by a tensile test of the resin layer remained after the removal of the copper foil from the copper foil composite by use of an acid. When the copper foil and the resin layer are laminated via an adhesive agent, the adhesive agent layer is removed by use of the solvent upon the measurements of F and f, so that the copper foil and the resin layer are peeled and can be separately subjected to the tensile test. T and t can be measured by observing sections of the copper foil composite with various microscopes such as an optical microscopy.

In addition, if the values of F and f of the copper foil and the resin layer are known before the copper foil composite is produced and if no heat treatment such that the properties of the copper foil and the resin layer are not greatly changed is conducted upon the production of the copper foil composite, the known values of F and f before the copper foil composite is produced may be used.

As described above, when (F x T)/(f x t) => 1 is satisfied, the ductility of the copper foil composite is increased and the elongation after fracture is also enhanced. Preferably, when the elongation after fracture of the copper foil composite is 30% or more, the copper foil composite is hardly cracked when it is bent to arrange the cable and the like, after the copper foil composite is wound around the outside of a material to be shielded such as the cable to provide a shielding material.

When the copper foil and the resin layer are cracked at the same time in the tensile test, this strain is used as the elongation after fracture of the copper foil composite. When only the copper foil is cracked first in the tensile test, the strain at the time of crack occurring is used as the elongation after fracture of the copper foil composite.

When (F x T) =< 3.1 (N/mm) is satisfied, the stiffness of the resin layer is decreased and the workability of the copper foil composite is enhanced. In addition, the copper foil and PET are hardly peeled, the ductility of the composite is enhanced, and the copper foil composite is hardly cracked when it is wound around the cable and bent. On the other hand, when (F x T) exceeds 3.1 (N/mm), not only the stiffness of the resin layer is increased, but also the strength of the resin layer is increased, so that the resin layer is easily peeled from the copper foil when the copper foil composite is deformed by pulling or bending, and the elongation after fracture of the composite may be decreased.

### [Example]

### 1. Electromagnetic shielding material

### <Production of the copper foil composite>

A tough-pitch copper ingot was hot-rolled, was surface grinded to remove oxides, was cold-rolled, was annealed and acid-pickled repeatedly to reduce the thickness untill the predetermined value was gained, and was finally annealed to ensure the workability, whereby each copper foil was provided. A tension upon cold-rolling and rolling conditions of the rolled material in a width direction were uniform so that the copper foil had uniform texture in the width direction. In the next annealing, a plurality of heaters were used to control the temperature so that a uniform temperature distribution was attained in the width direction, and the temperature of the copper was measured and controlled. A predetermined amount of Sn or Ag was added to some copper ingots to provide each copper foil.

A predetermined thickness of a commercially available biaxially-stretched film was bonded to the copper foil by a urethane based adhesive agent with a thickness of 3 µm, whereby each copper foil composite was provided.

### <Tensile test>

A plurality of strip tensile test specimens each having a width of 12.7 mm were produced from the copper foil composite. Some strip tensile test specimens were immersed in a solvent such as ethyl acetate to dissolve the adhesive agent layer and to peel the PET film and the copper foil. Thus, there were test specimens composed of the PET film alone and test specimens composed of the copper foil alone.

The tensile test was conducted under the conditions that a gauge length was 100 mm and the tension speed was 10 mm/min. An average value of N10 was employed for strength (stress) and elongation.

### <Crease performance of the copper foil composite >

The copper foil composites were wound around the outside of a cable having a diameter of 5 mm and the outside of a cable having a diameter of 2.5 mm, respectively, to produce longitudinally lapped shielded wires. The shielded wires were bent once at ± 180° and bending radius of 2.5 mm, and the crack of the copper foil composite was visually determined. The copper foil composite with no cracks is evaluated as Good.

The longitudinally lapped shielded wires were obtained by winding the copper foil composite in the longitudinal direction around the cable in the axial direction.

### <Workability of the copper foil composite>

When the above-mentioned longitudinally lapped shielded wires were produced, easy winding of the copper foil composite was evaluated as Good.

### 2. Copper foil composite for FPC

### <Production of the copper foil composite>

A tough-pitch copper ingot was hot-rolled, was surface grinded to remove oxides, was cold-rolled, was annealed and acid-pickled repeatedly to reduce the thickness untill the predetermined value was gained, and was finally annealed to ensure the workability, whereby each copper foil was provided. A tension upon cold-rolling and rolling conditions of the rolled material in a width direction were uniform so that the copper foil had uniform texture in the width direction. In the next annealing, a plurality of heaters were used to control the temperature so that a uniform temperature distribution was attained in the width direction, and the temperature of the copper was measured and controlled. A predetermined amount of Sn or Ag was added to some copper ingots to provide each copper foil.

A typical surface treatment used in CCL was conducted on the surface of the copper foil. The surface treatment is described in Japanese Examined Patent Publication No. Hei7-3237. After the surface treatment, a PI layer, i.e., the resin layer, was laminated on the copper foil by a lamination method to produce the CCL. When the PI layer was laminated on the copper foil, a thermoplastic PI based bonding layer was interposed. The resin film included the bonding layer and the PI film.

### <Tensile test>

A plurality of strip tensile test specimens each having a width of 12.7 mm were produced from the copper foil composite. Some strip tensile test specimens were immersed in a solvent (TPE3000 manufactured by Toray Engineering Co., Ltd.) to dissolve the adhesive agent layer and the PI film and to provide the test specimens each having only the copper foil. In some test specimens, the copper foils were dissolved with ferric chloride and the like to provide the test specimens each having only PI.

The tensile test was conducted under the conditions that a gauge length was 100 mm and the tension speed was 10 mm/min. An average value of N10 was employed for strength (stress) and elongation.

### <Workability of the copper foil composite>

The copper foil composite was tested according to W bending test at bending radius R = 0 mm (in accordance with Japan Copper and Brass Association Technical Standard JCBA T307). The copper foil composite with no cracks was evaluated as Good, and the copper foil composite with cracks was evaluated as Not Good.

The results of the electromagnetic shielding material are shown in Table 1, and the results of the copper foil composite for FPC are shown in Table 2.

**[Table 1]**

| | Copper foil | | Copper foil composite | | | | | | Evaluation | | | |
|---|---|---|---|---|---|---|---|---|---|---|---|---|
| | Content of added element(s) (mass ppm) | Elongation after fracture (%) | F (MPa) | T (mm) | f (MPa) | t (mm) | (F×T) /(f×t) | F×T (N/mm) | Elongation after fracture of copper foil composite(%) | Crease performance (diameter of 5mm) | Flexibility (diameter of 2.5mm) | Workability |
| Example 1 | - | 12.4 | 130 | 0.025 | 150 | 0.012 | 1.81 | 3.25 | 30 | Good | Cracked | Good |
| Example 2 | | 7.3 | 130 | 0.025 | 145 | 0.009 | 2.49 | 3.25 | 30 | Good | Cracked | Good |
| Example 3 | Sn:1200 | 9.3 | 130 | 0.025 | 174 | 0.007 | 2.67 | 3.25 | 30 | Good | Cracked | Good |
| Example 4 | - | 5.0 | 127 | 0.012 | 145 | 0.008 | 1.31 | 1.52 | 27 | Good | Cracked | Good |
| Example 5 | - | 5.8 | 80 | 0.025 | 149 | 0.008 | 1.68 | 2.00 | 34 | Good | Good | Good |
| Example 6 | - | 7.3 | 127 | 0.012 | 145 | 0.009 | 1.17 | 1.52 | 35 | Good | Good | Good |
| Example 7 | - | 9.3 | 127 | 0.012 | 98 | 0.009 | 1.73 | 1.52 | 42 | Good | Good | Good |
| Example 8 | Sn:200 | 7.3 | 127 | 0.012 | 155 | 0.008 | 1.23 | 1.52 | 33 | Good | Good | Good |
| Example 9 | Sn:900 | 7.6 | 127 | 0.012 | 163 | 0.008 | 1.17 | 1.52 | 35 | Good | Good | Good |
| Example 10 | Sn:1200 | 9.3 | 127 | 0.012 | 174 | 0.007 | 1.25 | 1.52 | 38 | Good | Good | Good |
| Example 11 | Sn:2000 | 12.5 | 127 | 0.012 | 180 | 0.008 | 1.06 | 1.52 | 31 | Good | Good | Good |
| Example 12 | Sn1000, Ag100 | 13.0 | 127 | 0.012 | 170 | 0.007 | 1.28 | 1.52 | 39 | Good | Good | Good |
| Comparative Example 1 | - | 3.5 | 127 | 0.012 | - | 0.008 | - | 1.52 | 12 | Cracked | Cracked | Good |
| Comparative Example 2 | - | 12.4 | 127 | 0.012 | 150 | 0.012 | 0.85 | 1.52 | 12 | Cracked | Cracked | Not Good |
| Comparative Example 3 | - | 9.3 | 127 | 0.006 | 98 | 0.009 | 0.86 | 0.76 | 13 | Cracked | Cracked | Good |
| Comparative Example 4 | Sn:1200 | 17.0 | 80 | 0.025 | 174 | 0.012 | 0.96 | 2.00 | 17 | Cracked | Cracked | Not Good |
| Comparative Example 5 | Sn:2000 | 22.2 | 130 | 0.025 | 185 | 0.020 | 0.88 | 3.25 | 20 | Cracked | Cracked | Not Good |

**[Table 2]**

| | Copper foil | | Copper foil composite | | | | | Evaluation | |
|---|---|---|---|---|---|---|---|---|---|
| | Content of added element(s) (mass ppm) | Elongation after fracture (%) | F (MPa) | T (mm) | f (MPa) | t (mm) | (F×T) /(f×t) | Elongation after fracture of copper foil composite(%) | Workability |
| Example 13 | - | 5.0 | 155 | 0.025 | 145 | 0.008 | 3.34 | 43 | Good |
| Example 14 | - | 12.4 | 150 | 0.038 | 150 | 0.012 | 3.17 | 48 | Good |
| Example 15 | - | 15.0 | 105 | 0.050 | 140 | 0.018 | 2.08 | 52 | Good |
| Example 16 | - | 23.3 | 105 | 0.050 | 135 | 0.035 | 1.11 | 55 | Good |
| Example 17 | Sn:200 | 7.3 | 150 | 0.038 | 155 | 0.008 | 4.60 | 48 | Good |
| Example 18 | Sn:900 | 7.6 | 155 | 0.025 | 163 | 0.008 | 2.97 | 45 | Good |
| Example 19 | Sn:1200 | 9.3 | 105 | 0.050 | 174 | 0.007 | 4.31 | 42 | Good |
| Example 20 | Sn:2000 | 12.5 | 105 | 0.050 | 180 | 0.008 | 3.65 | 44 | Good |
| Example 21 | Ag:100 | 6.7 | 105 | 0.050 | 115 | 0.012 | 3.80 | 50 | Good |
| Example 22 | Ag:200 | 9.1 | 105 | 0.050 | 101 | 0.035 | 1.49 | 53 | Good |
| Example 23 | Ag:300 | 7.1 | 155 | 0.025 | 98 | 0.012 | 3.30 | 47 | Good |
| Example 24 | Sn1000,, Ag100 | 13.0 | 105 | 0.050 | 127 | 0.007 | 5.91 | 33 | Good |
| Comparative Example 6 | Ag:200 | 9.0 | 100 | 0.012 | 105 | 0.035 | 0.33 | 8 | Cracked |
| Comparative Example 7 | - | 12.4 | 100 | 0.012 | 150 | 0.012 | 0.67 | 17 | Cracked |
| Comparative Example 8 | - | 23.3 | 155 | 0.025 | 135 | 0.035 | 0.82 | 18 | Cracked |
| Comparative Example 9 | Ag:100 | 6.7 | 100 | 0.012 | 115 | 0.012 | 0.87 | 8 | Cracked |

As apparent from Table 1, in Examples 1 to 12, (F x T)/(f x t) => 1 was satisfied, and both the crease performance and the workability of the copper foil composite was excellent. However, in Examples 1 to 3 where (F x T) exceeded 3.1 (N/mm), the crease performance of the cable having a diameter of 2.5 mm around which the copper foil composite was wound was poor, but the crease performance of the cable having a diameter of 5 m around which the copper foil composite was wound was good, therefore these can be used practically depending on the applications. In Example 4 where the elongation after fracture of the copper composite was less than 30%, the crease performance of the cable having a diameter of 2.5 mm around which the copper foil composite was wound was poor, but the crease performance of the cable having a diameter of 5 m around which the copper foil composite was wound was good, therefore these can be used practically depending on the applications.

In each Example other than Example 4, the elongation after fracture of the copper foil composite is 30% or more, and the ductility of the copper foil composite was excellent.

In addition, the copper foil composite in each Example was longitudinally lapped to the shielded wire, and the flexibility test of the shielded wires was conducted by applying repeatedly bending deformation to the shielded wires at ± 90° and at bending radius of 30 mm.

The flexibility of each Example was much better than that in each Comparative Example.

On the other hand, in Comparative Example 1 where the copper foil having the elongation after fracture of less than 5%, the strength of the copper foil was decreased, so that the stress f could not be measured and the flexibility was poor.

In Comparative Examples 2 to 5 where (F x T)/(f x t) was less than 1, the elongation after fracture of the copper foil composite was 20% or less, and the flexibility was poor, even though the copper foil having the elongation after fracture of 5% or more was used.

In Comparative Examples 1 to 5, the elongation after fracture of the copper foil composite was less than 30%, and the ductility of the copper foil composite was poor.

As apparent from Table 2, in Examples 13 to 24, (F x T)/(f x t) => 1 was satisfied, and the workability of the copper foil composite was good.

In Examples 13 to 24, the elongation after fracture of the copper foil composite was 30% or more, and the ductility was excellent.

On the other hand, in Comparative Examples 6 to 9, (F x T)/(f x t) was less than 1, the elongation after fracture of the copper foil composite was 20% or less even though the copper foil having the elongation after fracture of 5% or more was used, and thus the workability was poor.

In Comparative Examples 6 to 9, the elongation after fracture of the copper foil composite was less than 30%.

## Claims

1. A copper foil composite comprising a copper foil and a resin layer laminated thereon, wherein elongation after fracture of the copper foil is 5% or more, and wherein (F x T)/(f x t) => 1 is satisfied when t is a thickness of the copper foil, f is a stress of the copper foil under tensile strain of 4%, T is a thickness of the resin layer and F is a stress of the resin layer under tensile strain of 4%.

2. The copper foil composite according to Claim 1, wherein elongation after fracture of the copper foil composite is 30% or more.

3. The copper foil composite according to Claim 1 or 2, wherein (F x T) =< 3.1 (N/mm) is satisfied.

4. The copper foil composite according to any one of Claims 1 to 3, wherein the copper foil contains at least one selected from the group consisting of Sn, Mn, Cr, Zn, Zr, Mg, Ni, Si and Ag at a total concentration of 200 to 2000 mass ppm.

## Patentansprüche

1. Kupferfolien-Verbundmaterial, aufweisend eine Kupferfolie und eine Harzschicht, welche darauf aufgebracht ist, wobei die Ausdehnung nach Bruch der Kupferfolie 5% oder mehr beträgt, und wobei (F x T)/(f x t) ≥ 1 erfüllt ist, wenn t eine Dicke der Kupferfolie ist, f eine Spannung der Kupferfolie bei Zugverformung von 4% ist, T eine Dicke der Harzschicht ist und F eine Spannung der Harzschicht unter einer Zugverformung von 4% ist.

2. Kupferfolien-Verbundmaterial gemäß Anspruch 1, wobei die Ausdehnung nach Bruch des Kupferfolien-Verbundmaterials 30% oder mehr beträgt.

3. Kupferfolien-Verbundmaterial gemäß Anspruch 1 oder 2, wobei (F x T) ≤ 3,1 (N/mm) erfüllt ist.

4. Kupferfolien-Verbundmaterial gemäß einem der Ansprüche 1 bis 3, wobei die Kupferfolie mindestens eines aus der aus Sn, Mn, Cr, Zn, Zr, Mg, Ni, Si und Ag bestehenden Gruppe bei einer Gesamtkonzentration von 200 bis 2000 Massen-ppm enthält.

## Revendications

1. Composite en feuille de cuivre comprenant une feuille de cuivre et une couche de résine stratifiée sur celle-ci, dans lequel l'élongation après la rupture de la feuille de cuivre est supérieure ou égale à 5 %, et dans lequel (F x T)/(f x t) ≥ 1 est satisfaite lorsque t est une épaisseur de la feuille de cuivre, f est une contrainte de la feuille de cuivre pour un allongement en traction de 4 %, T est une épaisseur de la couche de résine et F est une contrainte de la couche de résine pour un allongement en traction de 4 %.

2. Composite en feuille de cuivre selon la revendication 1, dans lequel l'élongation après la rupture du composite en feuille de cuivre est supérieure ou égale à 30 %.

3. Composite en feuille de cuivre selon la revendication 1 ou 2, dans lequel (F x T) ≤ 3,1 (N/mm) est satisfaite.

4. Composite en feuille de cuivre selon l'une quelconque des revendications 1 à 3, dans lequel la feuille de cuivre contient au moins un élément choisi dans le groupe constitué par Sn, Mn, Cr, Zn, Zr, Mg, Ni, Si et Ag à une concentration totale de 200 à 2000 ppm en masse.
